# EUROPEAN PATENT SPECIFICATION

(11) **EP 0 916 238 B1**
(45) Date of publication and mention of the grant of the patent: **20.09.2000**
(21) Application number: 97936652.3
(22) Date of filing: 24.07.1997
(51) Int. Cl.: H05K 3/32

(54) **SURFACE MOUNTING PROCESS OF COMPONENTS FOR OSCILLATORS ON PRINTED CIRCUITS USING CONDUCTIVE EPOXY ADHESIVE**
VERFAHREN ZUR OBERFLÄCHENMONTAGE VON BAUELEMENTEN FÜR OSZILLATOREN AUF LEITERPLATTEN MITTELS LEITFÄHIGEN EPOXYDKLEBSTOFFS
PROCEDE DE MONTAGE EN SAILLIE DE COMPOSANTS POUR OSCILLATEURS SUR CIRCUITS IMPRIMES PAR UTILISATION DE COLLE EPOXYDE CONDUCTRICE

(30) Priority: 02.08.1996 IT MI961690
(43) Date of publication of application: 19.05.1999
(73) Proprietor: Italtel s.p.a., 20154 Milano (IT)
(72) Inventor: RICCI, Sergio, I-20063 Cernusco sul Naviglio (IT); TROMBETTA, Antonella, I-20133 Milano (IT)
(74) Representative: Giustini, Delio
(86) International application number: EP9704018
(87) International publication number: WO9806244

(56) References cited:
- EP-A- 0 593 155
- GB-A- 2 171 850
- US-A- 4 891 469
- B.T. ALPERT ET AL.: "Conductive adhesives as a soldering alternative" ELECTRONIC PACKAGING AND PRODUCTION., vol. 31, no. 11, November 1991, MASSACHUSETTS US, pages 130-132, XP000234064
- ENGINEER'S FACT FILE: "Screens and stencils" ELECTRONIC PACKAGING AND PRODUCTION., vol. 31, no. 4, April 1991, MASSACHUSETTS US, page 27 XP000202767
- "Variable-angle squeegee blade" IBM TECHNICAL DISCLOSURE BULLETIN., vol. 37, no. 4A, April 1994, NEW YORK US, page 241 XP000446655
- PATENT ABSTRACTS OF JAPAN vol. 16, no. 38 (E-1161), 30 January 1992 & JP 03 246988 A (NIPPONDENSO CO), 5 November 1991,

## Description

### Field of the Invention

The present invention relates to the sector of circuits with surface mounting for high frequency applications, and more precisely to a surface mounting process of components for high frequency generation circuits on printed circuits, using a conductive epoxy adhesive.

In the digital radio systems the high frequency generation circuits such as local oscillators carry out one of the most important and critical tasks to obtain the required system characteristics.

In order to get an appropriate project of frequency generation circuits at high frequency it is necessary to take into account different constraints as for example phase noise, long term frequency stability versus temperature, short term frequency instability always from the point of view to reduce the realization costs.

About the short term frequency instabilities these may occur in phase jumps or oscillation frequency of short duration casually generated due to the mechanical or thermic stresses either by the layer on which the layout of the oscillator is performed or depending of used components or of the alloys by which the components are soldered to the circuit, or of the general mechanic structures housing the circuit itself. These transients of short duration and rare occurrence over long periods of time and varying environmental conditions, generally caused by rapid variations of environmental temperature can be properly modeled as Frequency Steps (FS) in the internal frequency generation circuits. Normally the occurring frequency jumps are in the relative order of 1-2 ppm, i.e. 1 kHz for each GHz of oscillation frequency value.

These frequency steps become phase error transients internal to the carrier recovery loop utilized for coherent demodulation. They might cause an unwanted rotation of the I/O demodulation axis, leading to an "eye closing" conditions and hence to errors bursts or even to synchronization losses. The number of this errors is proportional to the level/order of modulation, due to the higher number and therefore to the relative proximity of the various points of the constellation of the modulation system.

At the actual state of the art regarding this sector there are no known examples for a solution of the technical problem of the frequency jumps caused by short term instability.

GB-A-2 171 850 discloses a surface mounting process of an unpackaged SAW component having transducers on one side of a substrate, including the steps of applying a conductive adhesive to predetermined areas of the printed wiring substrate so as to avoid producing an electrical connection between the different transducers, placing a SAW component over the printed wiring substrate so as to define a space between said component and the printing wiring substrate and sealing such space. B.T. Alpert et al.: "Conductive adhesives as a soldering alternative", Electronic Packaging and production, vol. 31, No. 11, pages 130-132 discloses and compares - in rather general terms - conductive adhesive soldering Available Conductive Surface Mount Adhesives (ACSMA).

EP-A-0 593 155 suggests to paint a non-conductive adhesive at an installation scheduled position of a substrate, and a conductive adhesive at the terminal areas of the wiring pattern, and heating the assembly after a diode body has been positioned over the substrate whereby the component is fixed to the substrate and connected to the wiring.

Engineer's Fact File: "Screens and Stencils", Electronic Packaging and production, vol. 31, No. 4, page 27 contains some information on screens for deposing solder paste onto a substrate.

"Variable Squeegee Blade", IBM Technical Disclosure Bullettin, vol. 37, No. 4A, page 241 refers to the use of metal blades in applying solder paste to the component pads. For the solution of said technical problem the discovery by the inventors has been determining that the frequency jumps are mainly due to:
* imperfect mechanical contacts within the oscillator resonator or in the tuning mechanism;
* solder joints, especially with reference to the normal and widespread use of tin alloys for soldering;
* unstable RF load impedance (frequency pulling);
* unstable reference crystal oscillator monitoring load impedance;
* unstable power supply voltage (frequency pushing);
* electromagnetic interference;
* mechanical shocks and vibrations.

### Summary of the Invention

According to the present invention the above-described technical problem has been solved by A process for realizing a frequency generation circuit on a printed circuit according to claim 1 and the appended claims.

The surface mounting process as the object of the present invention presents the main advantage to be of simple application, to use material to be easily found in commerce, such as multilayer printed circuits, even for highly professional applications, obtaining a substantial control of realization costs.

### Brief description of the Drawings

The invention, together with further objects and advantages thereof, may be understood with reference to the following description taken in conjunction with the accompanying drawings, and the several figures of which like referenced numerals identify like elements, and in which:

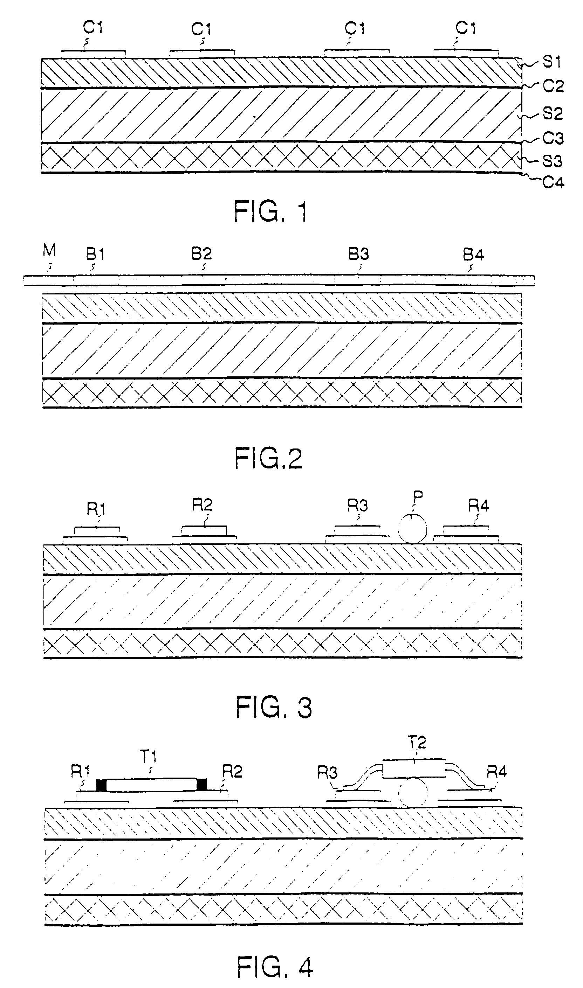

the figures 1 - 4 show the different phases of the process being the object of the invention.

The process according to the invention is based on the following steps realized one after the other:
A) Realization of frequency generation circuits and in particular of high frequency oscillators on traditional substrate, that is generally multilayer printed circuits with dimensions and routes of the track equivalent to the alumina substrate.
   For instance fig. 1 shows a cross section of a printed circuit CS with 4 layers realized in the known way; by S1, S2, S3 are indicated three layers of isolating material put between the metal layers C1, C2, C3, C4 setting up the conductive tracks. The upper track C1 is ecidenced as section of a series of circuit pads realized in the known way. The printed circuit is for instance realized on circuit board multiplexed FR4, plated with Ni - Au.
B) Screen printing process operation using electrical and thermal conductive epoxy adhesive on printed circuit.
   In the here described example the adhesive is one component, silver filled. Referring to fig. 2 the screen printing process is realized with a mask M being the negative of the printed circuit itself, for example using a stainless steel stencil.
   On said mask M are realized the holes or apertures B1, B2, B3, B4 placed in correspondence of the metallic circuit pads C1 of the printed circuit where the components have to be soldered.
   Moreover the holes or openings are of a smaller dimension than that of the circuit pads so that a crown of about 100 µm will remain covered by the mask.
   This is to guarantee that after the deposition the conductive adhesive will not go over the circuit pads due to the pressure carried out for the positioning of the components. The stencil M is placed in contact with the printed circuit.
   The screen printing process is realized by putting the adhesive on the stencil, for example with a steel squeegee, single or double element (typical thickness 100 µm), in double wet pass. Proceeding in this way the adhesive penetrates in the holes of mask.
   At the end the stainless steel stencil will be taken away with the result of the deposition of the adhesive in the wanted points on the circuit pads corresponding to the holes of the mask shown in fig. 3 with the areas R1, R2, R3, R4.
C) Positioning of the glue points or dots on the printed circuit in correspondence of the body of some components as the integrated circuits in surface mounting, as for example evidenced in fig. 3 by the dot P in order to increase the adhesion of said components which otherwise could be critical as a consequence to mechanical solicitations the printed circuits are subject to.
   The adhesive consists for example of isolating epoxy adhesive.
   The positioning of the isolating epoxy adhesive is carried out by a machine of the pick-and-place type.
D) Surface mounting of all components on the circuit board by a machine of the pick-and-place type.
   Fig. 4 shows the example of surface mounting of the components T1 and T2 on the conductive adhesive of the circuit pads R1, R2, R3, R4 respectively.
   T2 is moreover placed on the isolating adhesive dot P.
E) Curing of the adhesives. This is carried out using an air or nitrogen forced oven.
   A curing cycle is implemented which foresees an initial transient starting from environmental temperature and arriving at about 150°C within 5 minutes and a stay at that temperature for about 5 minutes at 150°C.
   At the end of the reticulation cycle the welding of all components on the printed circuit is realized.
F) The final scoring of the printed circuit by the circuit board.
   While a particular embodiment of the present invention has been shown and described, it should be understood that the present invention is not limited thereto since other embodiments may be made by those skilled in the art without departing from the scope thereof.
   It is thus contemplated that the present invention encompasses any and all such embodiments covered by the following claims.
   So is it for example possible to use other types of conductive epoxy adhesives such as for example bi-component ones.
   Other types of substrate may be used, as far as they are suitable for the use at high frequency.
   The screen printing process may be realized by a mesh screen with appropriate thickness emulsion.

## Claims

1. A process for realizing a frequency generation circuit on a printed circuit substrate, comprising the steps of:
- applying on said printed circuit a mask (M) provided with openings (B1 - B4) placed in correspondence with predetermined metallic circuit pads (C1) of the printed circuit, said opening having a smaller dimension than that of the underlying circuit pads (C1) whereby a pad crown will remain covered by said mask;
- laying a conductive epoxy adhesive on said mask (M) so as to make it penetrate in said openings;
- taking away said mask (M) leaving a deposition of said adhesive on the inner portion of said pads (R1, R2, R3, R4);
- surface mounting under pressure electronic components on said printed circuit substrate
- curing said conductive epoxy adhesive.

2. A process according to claim 1, characterized in that said conductive epoxy adhesive is applied on the printed circuits by a screen printing process.

3. A process according to claim 2, characterized in that said curing of the adhesive is carried out using an air or nitrogen forced oven implementing a curing cycle providing for an initial transient starting from environmental temperature and arriving at about 150°C within 5 minutes, and a stay at this temperature for about 5 minutes.

4. A process according to claim 3, characterized in that moreover an isolating epoxy adhesive is used to glue on the printed circuit at least some of said components, in order to increase the adhesion, putting it on said printed circuit before said surface mounting of the components on the printed circuit.

5. A process according to claim 3, characterized in that said mask (M) is a stainless steel stencil.

6. A process according to claim 3, characterized in that said mask (M) is a mesh screen with appropriate thickness emulsion.

7. A process according to claim 3, characterized in that said pad crown covered by the mask is about 100 µm on the edges of the circuit pads.

8. A process according to claim 3, characterized in that said laying of the adhesive on the mask (M) is carried out with a steel squeegee, single or double element.

9. A process according to any preceding claims, characterized in that said conductive epoxy adhesive is a silver filled one-component epoxy resin.

## Patentansprüche

1. Verfahren zur Realisierung einer Frequenzerzeugungsschaltung auf einem Leiterplattensubstrat, bei dem:
- auf die Leiterplatte eine Maske (M) aufgebracht wird, die mit Öffnungen (B1 - B4) versehen ist, die entsprechend vorbestimmter metallischer Schaltungskontaktstellen (C1) der Leiterplatte plaziert werden, wobei die Abmessung der Öffnung kleiner als die der darunterliegenden Schaltungskontaktstellen (C1) ist, wodurch eine Kontaktstellenkrone durch die Maske bedeckt bleibt;
- ein leitfähiger Epoxydklebstoff auf die Maske (M) aufgelegt wird, damit er in die Öffnungen eindringt;
- die Maske (M) entfernt wird, wodurch eine Ablagerung des Klebstoffs auf dem inneren Teil der Kontaktstellen (R1, R2, R3, R4) zurückbleibt;
- elektronische Bauelemente unter Druck auf dem Leiterplattensubstrat oberflächenmontiert werden
- der leitfähige Epoxydklebstoff ausgehärtet wird.

2. Verfahren nach Anspruch 1, dadurch gekennzeichnet, daß der leitfähige Epoxydklebstoff durch ein Siebdruckverfahren auf die Leiterplatte aufgebracht wird.

3. Verfahren nach Anspruch 2, dadurch gekennzeichnet, daß das Aushärten des Klebstoffs unter Verwendung eines mit Luft- oder Stickstoff durchströmten Ofens ausgeführt wird, wobei ein Aushärtzyklus implementiert wird, in dem eine anfängliche Transiente bereitgestellt wird, wobei mit Umgebungstemperatur begonnen und innerhalb von 5 Minuten ein Endwert von etwa 150°C erreicht und diese Temperatur etwa 5 Minuten gehalten wird.

4. Verfahren nach Anspruch 3, dadurch gekennzeichnet, daß außerdem eine isolierender Epoxydklebstoff verwendet wird, um mindestens einen Teil der Bauelemente auf die Leiterplatte aufzukleben, um die Haftwirkung zu vergrößern, indem er vor der Oberflächenmontage der Bauelemente auf die Leiterplatte aufgebracht wird.

5. Verfahren nach Anspruch 3, dadurch gekennzeichnet, daß die Maske (M) ein Umdruckspiegel aus rostfreiem Stahl ist.

6. Verfahren nach Anspruch 3, dadurch gekennzeichnet, daß die Maske (M) ein Maschensieb mit einer Emulsion entsprechender Dicke ist.

7. Verfahren nach Anspruch 3, dadurch gekennzeichnet, daß die durch die Maske bedeckte Kontaktstellenkrone etwa 100 am auf den Rändern der Schaltungskontaktstellen liegt.

8. Verfahren nach Anspruch 3, dadurch gekennzeichnet, daß das Auflegen des Klebstoffs auf die Maske (M) mit einem Stahlquetscher, Einzel- oder Doppelelement, ausgeführt wird.

9. Verfahren nach einem der vorangehenden Ansprüche, dadurch gekennzeichnet, daß der leitfähige Epoxydklebstoff ein Einkomponenten-Epoxydklebstoff mit Silberfüllung ist.

## Revendications

1. Procédé visant à réaliser un circuit générateur de fréquences sur un substrat de circuit imprimé, comprenant les étapes de :
- application sur ledit circuit imprimé d'un masque (M) pourvu d'ouvertures (B1 - B4) placées en correspondance avec des plages de connexion de circuit (C1) métalliques prédéterminées du circuit imprimé, lesdites ouvertures présentant une dimension inférieure à celle des plages de connexion de circuit sous-jacentes (C1) de façon à laisser une couronne de plages de connexion couverte par ledit masque;
- pose d'une colle époxyde conductrice sur ledit masque (M) de manière à la faire pénétrer dans lesdites ouvertures;
- retrait dudit masque (M) pour laisser un dépôt de ladite colle sur la partie intérieure desdites plages de connexion (R1, R2, R3, R4);
- montage en surface, sous pression, de composants électroniques sur ledit substrat de circuit imprimé;
- durcissement de ladite colle époxyde conductrice.

2. Procédé selon la revendication 1, caractérisé en ce que ladite colle époxyde conductrice est appliquée sur le circuit imprimé par un procédé sérigraphique.

3. Procédé selon la revendication 2, caractérisé en ce que ledit durcissement de la colle est mis en oeuvre à l'aide d'un four à circulation d'air ou d'azote réalisant un cycle de durcissement procurant une période transitoire initiale démarrant à la température ambiante pour atteindre environ 150°C en l'espace de 5 minutes et un séjour à cette température pendant environ 5 minutes.

4. Procédé selon la revendication 3, caractérisé en ce qu'une colle époxyde isolante est en outre utilisée pour coller au moins certains desdits composants sur le circuit imprimé, afin d'accroître l'adhésion, et placée sur ledit circuit imprimé préalablement audit montage en surface des composants sur le circuit imprimé.

5. Procédé selon la revendication 3, caractérisé en ce que ledit masque (M) est un pochoir en acier inoxydable.

6. Procédé selon la revendication 3, caractérisé en ce que ledit masque (M) est un écran à mailles avec une émulsion d'épaisseur adéquate.

7. Procédé selon la revendication 3, caractérisé en ce que ladite couronne des plages de connexion couverte par le masque est d'environ 100 µm sur les bords des plages de connexion de circuit.

8. Procédé selon la revendication 3, caractérisé en ce que ladite pose de la colle sur la masque (M) est mise en oeuvre à l'aide d'une raclette en acier, à simple ou double élément.

9. Procédé selon l'une quelconque des revendications précédentes, caractérisé en ce que ladite colle époxyde conductrice est une résine époxyde à un composant chargé à l'argent.
